# EUROPEAN PATENT APPLICATION

(11) **EP 2 330 542 A1**
(43) Date of publication of application: **08.06.2011**
(21) Application number: 09817804.9
(22) Date of filing: 30.09.2009
(51) Int. Cl.: G06K 19/077, B32B 15/092, G06K 19/07, H01Q 1/38

(54) **RF TAG AND METHOD FOR PRODUCING SAME**

(30) Priority: 30.09.2008 JP 2008253098
(71) Applicant: NOF Corporation, Shibuya-ku Tokyo 150-6019 (JP)
(72) Inventor: KUBOTA, Kazuhiro, Chita-gun Aichi 470-2398 (JP); OHTA, Toshihiro, Chita-gun Aichi 470-2398 (JP); MIZUGUCHI, Katsunobu, Chita-gun Aichi 470-2398 (JP)
(74) Representative: Behnisch, Werner
(86) International application number: PCT/JP2009/067020
(87) International publication number: WO 2010/038772

(57) **Abstract**

An RF tag which comprises a prepreg plate having a first dielectric layer (20a), and prepreg layers (30a, 30b) respectively arranged on the two major surfaces of the first dielectric layer (20a). The first dielectric layer (20a) is composed of a graft copolymer which is obtained by polymerizing 15-40 parts by mass of an aromatic vinyl monomer (b), which contains 70-95% by mass of a monofunctional aromatic vinyl monomer (b1) and 5-30% by mass of a bifunctional aromatic vinyl monomer (b2), onto 60-85 parts by mass of a polymer (a), which is obtained from an α-olefin monomer or a chain conjugated diene monomer. Each of the prepreg layers (30a, 30b) is composed of a glass fabric base impregnated with an epoxy resin. An antenna circuit (10) and a metal foil layer (40) are respectively bonded to the prepreg layers (30a, 30b) of the prepreg plate by thermal compression bonding.

## Description

### TECHNICAL FIELD

The present invention relates to a non-contact RF tag and a method for producing the same and, more particularly, to a non-contact RF tag which is formed by thermal compression bonding of layers with prepreg sheets therebetween and a method for producing the same.

### BACKGROUND ART

Along with progress of the advanced information society, frequency bands for signals used in communication devices and the like are shifting toward high-frequency bands which allow high information density transmission, such as the ultra high frequency (UHF) band and the super high frequency (SHF) band. The same holds true for Radio Frequency Identification (RFID) systems which have recently been attracting a lot of attention. An RFID system performs information transmission and reception by reading data from and writing data to a storage medium from and to which data can be read and written without contact. Improvements in semiconductor technology are facilitating miniaturization and sophistication of storage media to be used in RF tags. Due to their extended communication distances and improved communication stability, RF tags are expected to be used in a wide range of fields. In particular, an RF tag using a high-frequency band supplies power to a storage medium of the RF tag by using radio waves and has a significantly increased communication distance. An RFID system using such RF tags can perform batch reading of a plurality of RF tags, reading of a moving RF tag, and the like, which are difficult for an RFID system with a short communication distance.

Use of higher frequency bands in RFID systems significantly extends the range of applications but simultaneously makes environments in which the RFID systems are used harsh. Applications naturally include use in a cold district or a refrigeration facility and use under the flaming sun in summer. If an object on which an RF tag is to be installed is made of metal (e.g., a ship-borne container), the object has a wide temperature variation range due to conditions such as heat absorption and heat dissipation, and the RF tag is placed in a very harsh usage environment.

RF tags also have technical difficulty in using high-frequency bands. Since an electric signal with a higher frequency tends to suffer from a higher transmission loss, there is a great need for an electrical insulating material which supports high-frequency bands and has excellent high-frequency transmission characteristics. A transmission loss in a circuit in contact with an insulating material includes a conductor loss which is determined by the shape, the skin resistance, and the characteristic impedance of the antenna circuit and a dielectric material loss which is determined by the dielectric characteristics of a dielectric layer around the circuit. In particular, a high-frequency circuit may dissipate a transmission loss as a dielectric material loss to cause a malfunction in an electronic device. A dielectric material loss increases in proportion to the product of relative permittivity (ε) and a dielectric loss (tanδ) of a material. In order to minimize a dielectric material loss, a material which has both a low dielectric constant and a low dielectric loss needs to be used.

Among polymeric insulating materials, thermoplastic resins each have an excellently low dielectric constant and an excellently low dielectric loss and are easily processable. A thermoplastic resin is thus suitable as the material for a dielectric layer of an RF tag. Patent Document 1 discloses an RF tag having a dielectric layer formed by injection molding of a thermoplastic resin between a metal foil layer and an antenna circuit and that the RF tag can be installed on an object on which an RF tag is to be installed without shortening a communication distance, regardless of whether the object is a conductive object or a nonconductive object.
Patent Document 1: Japanese Patent Laid-Open No. 2008-9514

### SUMMARY OF INVENTION

### PROBLEMS THAT THE INVENTION IS TO SOLVE

The present inventors have noted drawbacks of the prior art. More specifically, in the prior art, members with significantly different linear expansion coefficients are bonded together, and residual stress is produced between the members. Accordingly, application of a load such as repetition of heating and cooling to an RF tag may cause interlayer peeling between members. If a small number of voids are left inside at the time of injection molding, local swelling and shrinking occurs to further increase the possibility of interlayer peeling.

An RFID system fulfills target functions such as ones related to a radiation pattern and gain by adjusting a working frequency and impedance matching for a storage medium. The adjustment is largely concerned with the relative permittivity of an RF tag and the thickness of a dielectric layer. A change in the dielectric constant of the entire RF tag resulting from addition of an air layer to a dielectric layer due to interlayer peeling and the difficulty of thickness control resulting from stress strain caused by bonding of members with different linear expansion coefficients are fatal problems in continuously using an RFID system. Use of several thousands to several tens of thousands of RF tags susceptible to interlayer peeling per system poses a significant financial risk to a user. Additionally, such RF tags have poor reusability, which leads to increased production costs.

Under the circumstances, the present invention has as its object to provide a reliable RF tag which has excellent transmission characteristics in high-frequency bands and can maintain desired transmission characteristics without causing a problem such as interlayer peeling even in an environment with wide variations in temperature.

### MEANS FOR SOLVING THE PROBLEMS

After keen examination for overcoming the drawbacks of the prior art, the present inventors have found a solution, use of a graft copolymer with a specific structure for a dielectric layer and use of a thermosetting sheet composed of a specific glass cloth base material-epoxy resin prepreg for bonding the dielectric layer, an antenna circuit, and a metal foil layer.

An RF tag according to one aspect includes a prepreg plate which is composed of a first dielectric layer (20a) and two prepreg layers (30a, 30b) which are arranged on two major surfaces, respectively, of the first dielectric layer (20a) and an antenna circuit (10) and a metal foil layer (40) which are stacked on the two prepreg layers (30a, 30b), respectively, of the prepreg plate. The first dielectric layer (20a) is made of a graft copolymer which is obtained by graft-polymerizing 15 to 40 parts by mass of an aromatic vinyl monomer (b), which contains 70 to 95% by mass of a monofunctional aromatic vinyl monomer (b1) and 5 to 30% by mass of a bifunctional aromatic vinyl monomer (b2), onto 60 to 85 parts by mass of a polymer (a), which is composed of a monomer unit derived from an α-olefin monomer or a chain conjugated diene monomer. Each of the two prepreg layers (30a, 30b) is an epoxy resin-impregnated glass fiber base material which is obtained by impregnating a glass fiber base material with an epoxy resin. The antenna circuit (10) includes a first conductive layer (12a) and an information readable-writable storage medium (11) mounted on the first conductive layer (12a). The two prepreg layers (30a, 30b) are bonded to the two major surfaces, respectively, of the first dielectric layer (20a) by thermal compression bonding. The antenna circuit (10) and the metal foil layer (40) are bonded to the two prepreg layers (30a, 30b), respectively, of the prepreg plate by thermal compression bonding.

According to this configuration, the first dielectric layer (20a) is made of a specific graft copolymer. The graft copolymer is substantially composed of hydrocarbon groups and does not include polar groups. The graft copolymer thus exhibits a low dielectric constant and a low dielectric loss and has excellent high-frequency characteristics. Also, the graft copolymer has a structure in which a monomer unit derived from the aromatic vinyl monomer (b) forms a domain with respect to the polymer (a) as a matrix. The graft copolymer dissolves only partially in an organic solvent and does not suffer from sagging due to heat even at a temperature equal to more than the melting point. For this reason, the graft copolymer can tolerate thermal compression bonding of the prepreg layers (30a, 30b), formation of voids between the first dielectric layer (20a) and each prepreg layer is inhibited, and adhesion between the layers is improved. Additionally, the prepreg layers (30a, 30b) are each a prepreg sheet which is obtained by impregnating a glass fiber base material (S1) with an epoxy resin (S2) and cure by thermal compression bonding at, e.g., 140 to 180°C. The prepreg layers (30a, 30b) can strengthen the bonds between the two major surfaces of the first dielectric layer (20a) and the antenna circuit (10) and metal foil layer (40) and can maintain desired durability after bonding.

Accordingly, the RF tag has excellent high-frequency transmission characteristics and is capable of maintaining desired transmission characteristics for a change in temperature in a usage environment.

In one example, the first conductive layer (12a) and the metal foil layer (40) are electrically continuous. According to this configuration, an antenna function of the antenna circuit (10) with the information readable-writable storage medium (11) mounted on the first conductive layer (12a) can be imparted to the metal foil layer (40). This contributes to miniaturization of RF tags.

In one example, the RF tag includes a second dielectric layer (20b) and a second conductive layer (12b) which are stacked in this order on one opposite to the prepreg layer (30b) of surfaces of the first conductive layer (12a), and the first conductive layer (12a) and the second conductive layer (12b) are electrically continuous, and the second dielectric layer (20b) is made of a graft copolymer which is obtained by graft-polymerizing 15 to 40 parts by mass of the aromatic vinyl monomer (b), which contains 70 to 95% by mass of the monofunctional aromatic vinyl monomer (b1) and 5 to 30% by mass of the bifunctional aromatic vinyl monomer (b2), onto 60 to 85 parts by mass of the polymer (a), which is composed of the monomer unit derived from the α-olefin monomer or the chain conjugated diene monomer, and the first conductive layer (12a), the second dielectric layer (20b), and the second conductive layer (12b) are bonded in this order by thermal compression bonding. This configuration allows further miniaturization of RF tags.

A method for producing an RF tag according to one aspect includes a step (A) and a step (B). The step (A) is a step of bonding the two prepreg layers (30a, 30b) to the two major surfaces, respectively, of the first dielectric layer (20a) by thermal compression bonding and producing the prepreg plate, and the step (B) is a step of bonding the antenna circuit (10) and the metal foil layer (40) to the two prepreg layers (30a, 30b), respectively, of the prepreg plate by thermal compression bonding. According to this configuration, an RF tag with improved interlayer bonding strength can be efficiently produced by a simple process.

### BRIEF DESCRIPTION OF THE DRAWINGS

Fig. 1 is an exploded cross-sectional view of an RF tag according to an embodiment.
Figs. 2(a) to 2(c) are cross-sectional views showing a process of producing the RF tag in Fig. 1, and Fig. 2(d) is a cross-sectional view of an RF tag according to a modification in which a storage medium is housed in a recessed portion.
Fig. 3 is a cross-sectional view of an RF tag according to a modification.
Figs. 4(a) to 4(e) are schematic perspective views of RF tags configured for electrical continuity.

### DESCRIPTION OF EMBODIMENTS

An embodiment of the present invention will be described in detail below.

An RF tag according to this embodiment includes a prepreg plate in which two prepreg layers (30a, 30b) are bonded to two major surfaces, respectively, of a first dielectric layer (20a) by thermal compression bonding and an antenna circuit (10) and a metal foil layer (40) which are bonded to the two prepreg layers (30a, 30b), respectively, of the prepreg plate by thermal compression bonding. This RF tag has good transmission characteristics in high-frequency bands and is capable of maintaining desired performance for a change in temperature. Components of the RF tag will now be described in turn.

### DIELECTRIC LAYER (20)

The dielectric layer (20) is made of a graft copolymer obtained by graft-polymerizing an aromatic vinyl monomer (b) onto a polymer (a) which is composed of a monomer unit derived from an α-olefin monomer or a chain conjugated diene monomer. Constitutional units of the dielectric layer (20) are a unit of the polymer (a) derived from an α-olefin monomer or a chain conjugated diene monomer and a unit derived from the aromatic vinyl monomer (b). Each unit is substantially composed of hydrocarbon groups. These units do not include polar groups with high dipole moment, and a polymer formed from the units exhibits a low dielectric constant and a low dielectric loss. Accordingly, the dielectric layer (20) has good high-frequency characteristics.

The dielectric layer (20) is made of a graft copolymer obtained by grafting the aromatic vinyl monomer (b) onto the polymer (a), which is composed of a monomer unit of an α-olefin monomer or a chain conjugated diene monomer. The graft copolymer is considered to have a molecular form in which a unit of the polymer (a) forms a matrix, and a unit of the aromatic vinyl monomer (b) forms a domain. For this reason, the dielectric layer (20) dissolves only partially in an organic solvent or the like, does not turn into liquid to flow even at a temperature equal to or more than the melting point, and is less susceptible to sagging due to heat. A unit of the polymer (a) forms a main chain structure (trunk component) of the graft copolymer whereas a unit of the aromatic vinyl monomer (b) forms a side chain structure (graft or branch component) of the graft copolymer.

The α-olefin monomer is specifically an α-olefin which is given by the general formula R-CH=CH₂ (where R represents an alkyl group with a carbon number of 1 to 16) and whose carbon number is 3 to 18. Examples of the α-olefin monomer include propylene, butene-1, pentene-1, hexene-1, octene-1, decene-1, 4-methylpentene-1, 4-methylhexene-1, and 4,4-dimethylpentene-1. Among them, at least one selected from the group consisting of propylene, butene-1, hexene-1, octene-1, and 4-methylpentene-1 is preferably used as the α-olefin monomer.

The chain conjugated diene monomer is specifically a chain conjugated diene compound whose carbon number is 3 to 10. The term chain refers to a straight chain or a branched chain. Examples of the chain conjugated diene monomer include isoprene, 1,3-butadiene, 2,3-dimethyl-1,3-butadiene, 1,3-pentadiene, and 1,3-hexadiene. Among them, isoprene and 1,3-butadiene are preferable as the chain conjugated diene monomer, and 1,3-butadiene is particularly preferable.

The main chain structure of the graft copolymer is a polymer which is composed of a monomer unit derived from the α-olefin monomer or the chain conjugated diene monomer. The polymer may be a monopolymer or a copolymer and may also be referred to as a homopolymer/copolymer. If the main chain structure is a copolymer, the copolymer may be a random copolymer or a block copolymer. The monomer unit derived from the α-olefin monomer or the chain conjugated diene monomer may be a mixture of a plurality of types of monomer units. The chain conjugated diene monomer unit in the main chain structure may be partially hydrogenated.

The aromatic vinyl monomer to be grafted onto the main chain structure described above is specifically an aromatic vinyl compound whose carbon number is 8 to 18. Examples of a monofunctional aromatic vinyl monomer (b1) include styrenic monomers such as styrene, p-methylstyrene, and α-methylstyrene. Examples of a bifunctional aromatic vinyl monomer (b2) include divinylbenzene and 1,3-divinyl naphthalene. As each of the monofunctional aromatic vinyl monomer (b1) and the bifunctional aromatic vinyl monomer (b2), one type may be used alone or two or more types may be used in combination.

The proportions of the polymer (a) and the aromatic vinyl monomer (b) used to form the graft copolymer are 60 to 85 parts by mass and 15 to 40 parts by mass, and more preferably 65 to 75 parts by mass and 125 to 35 parts by mass. If the proportion of the aromatic vinyl monomer (b) is less than 15 parts by mass, the graft copolymer clearly exhibits characteristics of α-olefinic polymers or chain conjugated diene polymers and exhibits extremely high flowability at temperatures equal to or higher than the melting point, thus resulting in the difficulty of thickness control. On the other hand, if the proportion of the aromatic vinyl monomer (b) is more than 40 parts by mass, the graft copolymer is very brittle and is hard to be formed into a plate.

The proportions of the monofunctional aromatic vinyl monomer (b1) and the bifunctional aromatic vinyl monomer (b2) to the aromatic vinyl monomer (b) are 70 to 95% by mass and 5 to 30% by mass. If the proportion of the bifunctional aromatic vinyl monomer is less than 5% by mass, the function of the bifunctional aromatic vinyl monomer does not manifest itself sufficiently. On the other hand, if the proportion of the bifunctional aromatic vinyl monomer is more than 30% by mass, the graft copolymer is very brittle and is hard to be formed into a plate.

The graft copolymer for forming the dielectric layer (20) may be produced by any grafting method (e.g., chain transfer using a peroxide, ionizing radiation irradiation, or a method using a polymerization initiator). A preferred method is impregnation graft polymerization to be described below. Impregnation graft polymerization has high graft efficiency and does not cause secondary aggregation due to heat. According to impregnation graft polymerization, intended performance is more effectively achieved, and the graft copolymer can be easily produced. If impregnation graft polymerization is adopted, the graft copolymer is generally produced by the method below. First, 100 parts by mass of the polymer which is composed of at least one monomer selected from α-olefin monomers and chain conjugated diene monomers is suspended in water. A mixture of one, two, or more radical copolymerizable organic peroxides in an amount of 0.1 to 10 parts by mass to 100 parts by mass of the aromatic vinyl monomer and a radical polymerization initiator whose decomposition temperature for achieving a half-life of 10 hours is 40 to 90°C in an amount of 0.01 to 5 parts by mass to 100 parts by mass of the total amount of the aromatic vinyl monomer and the radical copolymerizable organic peroxides are dissolved in the aromatic vinyl monomer in an amount of 5 to 400 parts by mass to prepare a separate solution.

The radical copolymerizable organic peroxides are impregnated into the main chain structure of the polymer. After that, the temperature of the aqueous suspension is set such that the radical polymerization initiator does not decompose substantially. The aromatic vinyl monomer and the radical copolymerizable organic peroxides are copolymerized in the main chain structure to obtain a grafted precursor. The radical copolymerizable organic peroxides are each a compound which has both properties of radical copolymerizable monomers and properties of organic peroxides in a single molecular. Preferred examples of the radical copolymerizable organic peroxides include t-butyl peroxyacryloyloxyethyl carbonate, t-butyl peroxymethacryloyloxyethyl carbonate, t-butyl peroxyallyl carbonate, and t-butyl peroxymethallyl carbonate. The most preferred one among them is t-butyl peroxymethacryloyloxyethyl carbonate.

The target graft copolymer can be obtained by melting and kneading the main chain structure after the impregnation at 100 to 300°C. Examples of a method for the melting and kneading include a method using a Banbury mixer provided with a heating function and a kneading function and a method using a single or twin screw extruder. Among these methods, a method in which a screw extruder is used, a grafted precursor is fed from a main hopper and is melted and kneaded, and a rod-like molded article extruded from a die is passed through a pelletizer to obtain pelletized articles (pellets) is preferable because the method is convenient and inexpensive.

Common additives such as a lubricant, a plasticizing agent, a nucleating agent, an ultraviolet rays protective agent, a colorant, a fire retardant, an antioxidant, and a heavy metal deactivator may be added to the obtained graft copolymer without adversely affecting the object of the present invention. A method for kneading the graft copolymer and the additives is not particularly limited. The graft copolymer and the additives can be kneaded by using a Banbury mixer provided with a heating function and a kneading function, a pressure kneader, a roll, a single or twin screw extruder, or the like. A twin screw kneader is particularly preferable. The graft copolymer with the additives can be prepared under the same conditions as those for obtaining the graft copolymer.

As a method for obtaining a sheet-like molded article serving as a dielectric layer (P) by using a graft copolymer obtained by the copolymerization described above or a blend of the graft copolymer and additives, any method (e.g., the T-die method, inflation molding, roll forming, press molding, or injection molding) may be used. Roll forming or injection molding is preferably adopted because the method is unlikely to cause warpage in a sheet-like molded article.

### PREPREG LAYERS (30a, 30b)

A prepreg sheet used to form the prepreg layers (30a, 30b) is a prepreg sheet in a semicured state (so-called B-stage) which is obtained by impregnating a glass fiber base material (S1) with an uncured epoxy resin (S2) serving as a thermosetting resin.

### GLASS FIBER BASE MATERIAL (S1)

The glass fiber base material (S1) is intended to impart rigidity required for an RF tag to a prepreg sheet. Glass is selected as the type of the material for a prepreg sheet in order to achieve electrical characteristics required for an RF tag for high-frequency bands. As the glass, E-glass, C-glass, A-glass, S-glass whose dielectric characteristics are improved by increasing the content of silicon dioxide (SiO₂), D-glass, or quartz glass is used. Examples of the form of the fiber include a continuous mat, a cloth, a non-woven fabric, a roving cloth, a surfacing mat, and a chopped strand mat. The form may be appropriately selected depending on the uses and the performance of an article to be molded. Among the examples, a cloth is preferable.

As the glass fiber base material (S1), one which is optionally subjected to insulating coating and surface treatment with a silane compound (chlorosilane, alkoxysilane, organofunctional silane, or silazane), a coupling agent (titanate or aluminum coupling agent), or the like without adversely affecting the electrical characteristics may be used.

The proportion of the glass fiber base material (S1) in each prepreg sheet is preferably 10 to 60% by mass, and more preferably 15 to 45% by mass. If the proportion is less than 10% by mass, the viscosity of the composition increases excessively to reduce the workability, and coarse separation occurs in the thermosetting material to reduce the strength of the prepreg sheet. On the other hand, if the proportion is more than 60% by mass, the adhesion between the epoxy resin (S2) and the glass fiber base material (S1) is insufficient, the epoxy resin (S2) is not sufficiently effective in improving the toughness, and the low dielectric constant characteristic and the low dielectric loss characteristic of the prepreg sheet are poorer in high-frequency bands.

### EPOXY RESIN (S2)

The epoxy resin (S2) used in each prepreg sheet is not particularly limited. Bisphenol A type epoxy resins, bisphenol F type epoxy resins, bisphenol S type epoxy resins, aminoglycidyl type epoxy resins, aminophenol type epoxy resins, novolac type epoxy resins, naphthalene type epoxy resins, aliphatic epoxy resins, alicyclic epoxy resins, and the like are used. Among the resins, bisphenol-based epoxy resins such as bisphenol A type epoxy resins, bisphenol F type epoxy resins, and bisphenol S type epoxy resins are particularly preferable because use of the resins improves the heat resistance and the mechanical strength of the prepreg sheet.

Examples of the type of each prepreg include a unidirectional prepreg, a cloth prepreg, a yarn prepreg, a mat prepreg, and a roving prepreg. A mat prepreg or a cloth prepreg is preferably used. The thickness of the prepreg sheet is generally 20 to 400 µm, preferably 30 to 300 µm, and more preferably 40 to 200 µm A single prepreg sheet may be used or a plurality of stacked prepreg sheets may be used.

### ANTENNA CIRCUIT (10)

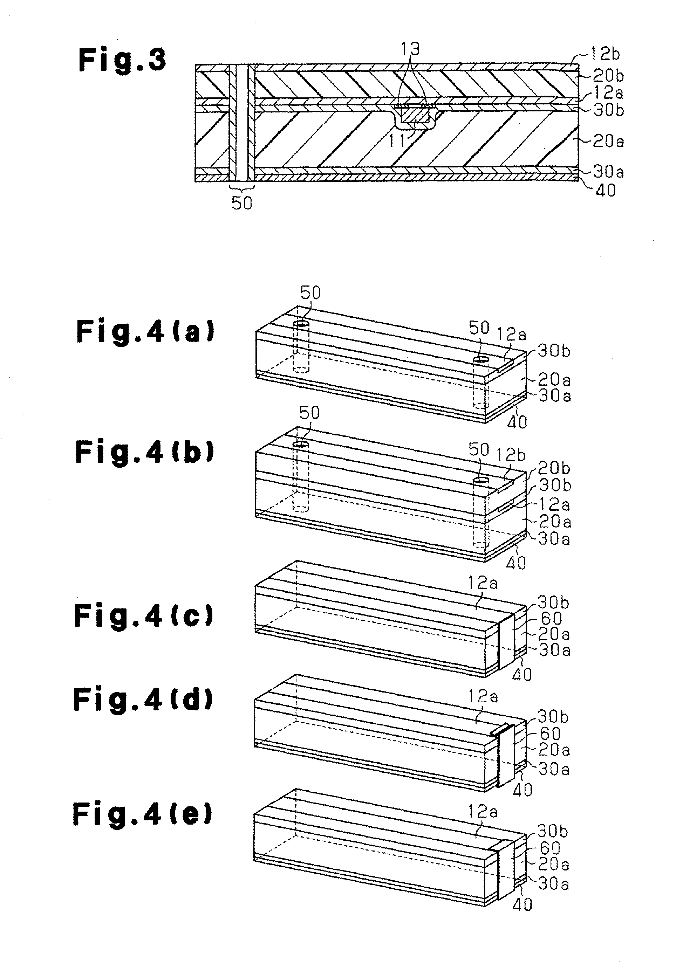

The antenna circuit includes a conductive layer (12) with an information readable-writable storage medium (11) mounted thereon. The conductive layer (12) and the storage medium (11) are electrically bonded by an arbitrary method. As the electrical bonding method, a known method such as solder bonding or conductive paste bonding may be adopted. Provision of electrical continuity between the conductive layer (12), which is bonded to the storage medium, and the metal foil layer (40) makes it possible to impart an antenna function of the antenna circuit (10) to the metal foil layer (40). The shape of the antenna circuit (10) is not particularly limited, and the antenna circuit (10) can have various shapes such as a strip shape (see Figs. 4(a) to 4(e)), a ring shape, and a coil shape.

### CONDUCTIVE LAYER (12)

The conductive layer (12) is formed by using a metal foil made of an elemental metal such as copper, aluminum, iron, nickel, or zinc or an alloy of the metals. A metal foil having undergone surface treatment for rust prevention can be optionally used as the metal foil. A metal foil produced by electrolysis or rolling can be used as the metal foil. The metal foil may be formed by vacuum deposition or plating. Different types of metal foils may be used for a first conductive layer (12a) and a second conductive layer (12b).

### STORAGE MEDIUM (11)

A storage medium which includes a communication circuit for storing and reading information without contact, a memory, and a predetermined control circuit and also includes a chip electrode for electrically connecting with the conductive layer (12) can be used as the storage medium (11).

### METAL FOIL LAYER (40)

A foil-like or thin plate-like metal sheet or a porous foil-like or thin plate-like metal mesh such as a metal net or expanded metal can be used as the metal foil layer (40). The thickness of the metal foil layer (40) is preferably 5 to 100 µm, and more preferably 5 to 50 µm If the thickness is less than 5 µm, the electrical resistance of a conductor circuit is too high. On the other hand, if the thickness is more than 100 µm, a conductor circuit is likely to break by side etching when the conductor circuit is to be formed by etching.

The type of the metal used in the metal foil layer (40) is not particularly limited. Aluminum, titanium, iron, copper, nickel, nichrome, tin, lead, magnesium, gold, silver, platinum, other various metals, and alloys of the metals can be used.

### METHOD FOR PRODUCING RF TAG

A preferable RF tag is obtained by performing a step (A) and a step (B).

The step (A) is a step of bonding the two prepreg layers (30a, 30b) to the two major surfaces, respectively, of the first dielectric layer (20a) by thermal compression bonding to produce a prepreg plate. Each of the prepreg layers (30a, 30b) can be derived from a prepreg sheet.

The step (B) is a step of bonding the antenna circuit (10) and the metal foil layer (40) to the two prepreg layers (30a, 30b), respectively, of the prepreg plate formed through the step (A) by thermal compression bonding.

The thermal compression bonding in the step (A) and the thermal compression bonding in the step (B) may be simultaneously performed. In this case, the RF tag may be formed by one thermal compression bonding operation.

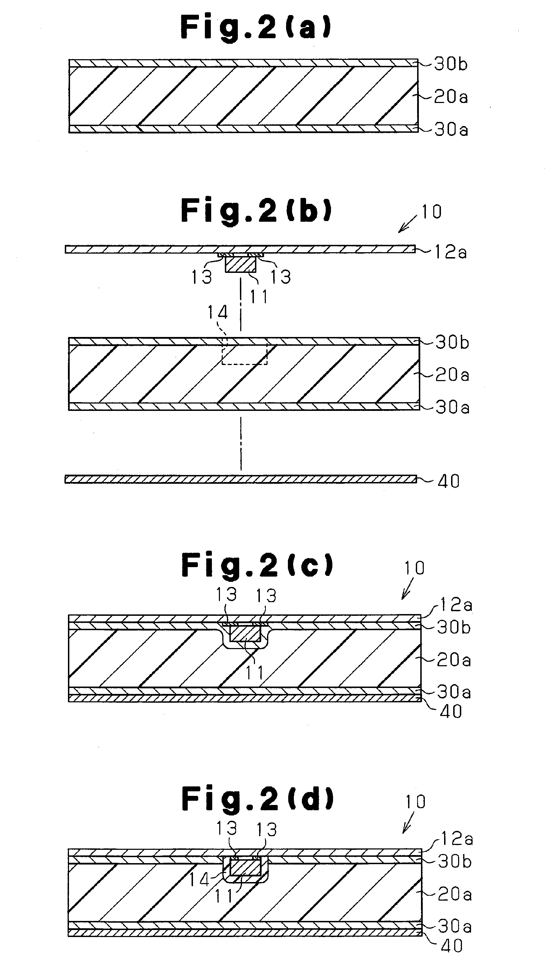

Before the step (B), a recessed portion (14) may be formed by drilling at a position of the prepreg plate where the storage medium (11) is to be arranged (see Fig. 2(b)). In this case, the storage medium (11) mounted on the antenna circuit (10) can be housed in the recessed portion (14) so as not to project outwardly from the outermost surface of the RF tag (see Fig. 2(d)). In the example shown in Fig. 2(d), a gap between the recessed portion (14) and the storage medium (11) is filled with an epoxy resin serving as an example of a filler. The recessed portion (14) may be formed so as not to leave a gap between the storage medium (11) and the recessed portion (14), thereby eliminating the need to use a filler.

In the dielectric layer (20), a graft copolymer has a molecular form in which an aromatic vinyl monomer is grafted to a random or block copolymer composed of a monomer unit derived from an α-olefin monomer or a chain conjugated diene monomer. A unit of the aromatic vinyl monomer thus forms a domain with respect to a matrix. The dielectric layer (20) dissolves only partially in an organic solvent or the like, does not turn into liquid to flow even at a temperature equal to or more than the melting point, and is less susceptible to sagging due to heat. Accordingly, the dielectric layer (20) can tolerate thermal compression bonding within the operating temperature range of the prepreg layers (30a, 30b). This configuration allows application of uniform contact pressure by thermal compression bonding and production of an RF tag which has improved interlayer bonding strength and is less susceptible to interlayer peeling.

A prepreg plate produced by the step (A) has two major surfaces provided by the insulating prepreg layers (30a, 30b). The antenna circuit (10) and the metal foil layer (40) are bonded to the insulating prepreg layers (30a, 30b) by thermal compression bonding. This laminated structure can prevent a reduction in the communication distance of an RF tag even if an object to which the RF tag is to be attached is a conductive material.

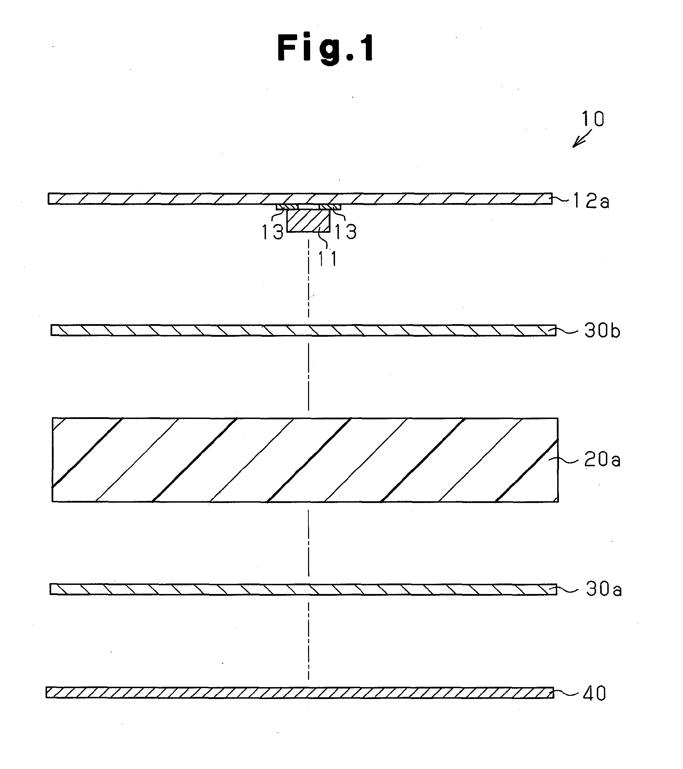

The basic configuration of an RF tag will be described. An RF tag in Fig. 1 is composed of the first dielectric layer (20a) made of the graft copolymer described above, the two prepreg layers (30a, 30b) stacked on the two major surfaces, respectively, of the first dielectric layer (20a), the antenna circuit (10) stacked on one of the prepreg layers, and the metal foil layer (40) stacked on the other prepreg layer and serving as a conductor. Each prepreg layer can be formed of, e.g., a glass epoxy resin. The antenna circuit (10) includes the first conductive layer (12a) and the storage medium (11) bonded to the inner surface side of the first conductive layer (12a) with solder (13).

A method for producing an RF tag will be described. As shown in Fig. 2(a), the prepreg layers (30a, 30b) are bonded to the two major surfaces, respectively, of the first dielectric layer (20a) by thermal compression bonding. A laminated body composed of the first dielectric layer (20a) and the prepreg layers (30a, 30b) may be referred to as a prepreg plate.

As shown in Fig. 2(b), the storage medium (11) is mounted above the first conductive layer (12a) through the solder (13) mounted on the inner surface side of the first conductive layer (12a). The first conductive layer (12a) and the storage medium (11) constitute the antenna circuit (10).

After the prepreg plate and the antenna circuit (10) are prepared, the antenna circuit (10) is arranged such that the storage medium (11) faces inward, i.e., the storage medium (11) faces one of the prepreg layer of the prepreg plate. At the same time, the metal foil layer (40) is overlaid on the other prepreg layer of the prepreg plate. By thermal compression bonding in this state, the antenna circuit (10) and the metal foil layer (40) are bonded to the prepreg plate to obtain an RF tag shown in Fig. 2(c). At the time of the thermal compression bonding, the storage medium (11) is press-fit into and buried in the prepreg layer (30b) and the first dielectric layer (20a).

An RF tag according to a modification will be concretely described. In the RF tag according to the modification, the first conductive layer (12a) and the metal foil layer (40) are electrically continuous. Electrical continuity can be provided by an arbitrary method such as connection using a conductive material, use of a via, or use of an end face electrode. (See Figs. 4(a) to 4(e).)

### VIA (50)

Electrical continuity between the conductive layers can be provided by a via. Examples of a via include a through via extending through the dielectric layer in a direction of thickness and a blind via. A via can be produced by forming a via hole by, e.g., laser processing or drilling and forming a plated layer on the inner surface of the via hole or filling the via hole with a conductor plug. The number and positions of vias are not particularly limited, and an arbitrary number of vias can be arranged at arbitrary positions.

### END FACE ELECTRODE (60)

Electrical continuity between the conductive layers can be provided by an end face electrode (60). The end face electrode is arranged on an outer surface (a side surface or an end surface) of the dielectric layer to extend in a direction of the thickness of the dielectric layer. In one example, the end face electrode (60) can be formed by applying conductive paste or metal plating to an end face of the RF tag. In another example, the end face electrode (60) can also be composed of a conductor such as a square bracket-shaped ("]"-shaped) metal fastener, conductive tape made of aluminum or carbon, or the like. The number and positions of end face electrodes (60) are not particularly limited, and an arbitrary number of end face electrodes (60) can be arranged at arbitrary positions.

The via (50) and the end face electrode (60) described above may be used in combination.

An RF tag according to another modification of the present invention will be described. As shown in Fig. 3, the RF tag includes a second dielectric layer (20b) and a second conductive layer (12b) stacked in this order on one of the surfaces of the first conductive layer (12a) of the RF tag according to the embodiment which is opposite to the prepreg layer (30b), and the first conductive layer (12a) and the second conductive layer (12b) are electrically continuous. Provision of electrical continuity may be provided by an arbitrary method such as connection using a conductive material, use of a via, or use of an end face electrode. See the above description for a via and an end face electrode. In the example in Fig. 3, a through via connecting the first dielectric layer (20a) and a second dielectric layer (20b) is formed. Alternatively, a via connecting the first conductive layer (12a) and the second conductive layer (12b) may be formed, a via connecting the first conductive layer (12a) and the metal foil layer (40) may be formed, or the vias may be formed in combination. Bonding of the second dielectric layer (20b) and the first conductive layer (12a) and bonding of the second dielectric layer (20b) and the second conductive layer (12b) can be performed simultaneously or separately by thermal compression bonding. For example, the second dielectric layer (20b) and the second conductive layer (12b) may be bonded in advance by thermal compression bonding, the second dielectric layer (20b) may be then arranged to cover the antenna circuit (10), and the second dielectric layer (20b) and the first conductive layer (12a) may be bonded by thermal compression bonding. Alternatively, the second dielectric layer (20b) and the second conductive layer (12b) may be stacked to cover the antenna circuit (10), and the second dielectric layer (20b) and the second conductive layer (12b) in this state may be bonded by thermal compression bonding. If the first conductive layer (12a) of the antenna circuit (10) is overlaid not on the entire surface but on a part of the prepreg (30b), the second dielectric layer (20b) may be partially bonded to a portion of the major surface of the prepreg (30b) which does not overlap with the first conductive layer (12a). See the above description of the steps A and B for thermal compression bonding.

A protective layer covering the first conductive layer (12a) in Fig. 1 or the second conductive layer (12b) in Fig. 3 may be optionally provided.

### EXAMPLES

The embodiment will be more concretely described below with reference to synthesis examples, examples, and comparative examples. An RF tag evaluation method used in each example will be described first.

### EVALUATION OF ENVIRONMENTAL RESISTANCE

Environmental resistance determination was performed by a heat cycle resistance test and high temperature and high humidity resistance. The form of an evaluation sample is shown below.
RF tag: 90 mm in length, 50 mm in width, and 4 mm in thickness
Antenna circuit (10): 90 mm in length and 40 mm in width
Metal foil (M): 90 mm in length and 55 mm in width

### HEAT CYCLE RESISTANCE

Heat cycle resistance determination was performed by placing an RF tag specimen into heat cycle resistance evaluation equipment. The number of cycles when interlayer peeling was found through a visual RF tag check and a rate of change of the value of inter-antenna-circuit resistance from its initial value and a rate of change of the value of inter-GND-pattern resistance from its initial value when 500 cycles were reached were used as performance indices.
Testing conditions: at temperatures of -20°C and +60°C for 30 minutes each

### HIGH TEMPERATURE AND HIGH HUMIDITY RESISTANCE

High temperature and high humidity resistance determination was performed by placing an RF tag specimen into a constant temperature and constant humidity bath. The number of cycles when interlayer peeling was found through a visual RF tag check and a rate of change of the value of inter-antenna-circuit resistance from its initial value and a rate of change of the value of inter-GND-pattern resistance from its initial value when 500 hours were reached were used as performance indices.
Testing conditions: at a temperature of 80°C and a relative humidity of 85%

In each of the above-described tests, inter-antenna-circuit electrical continuity and inter-GND-pattern electrical continuity were evaluated by measuring conductor resistivity when a current of 0.5 A was supplied to a portion to which a storage medium (11) of an antenna circuit (10) is electrically connected and obtaining a rate of change of the conductor resistivity from its initial value. For an RF tag which suffered peeling within less than 500 cycles after the RF tag was placed into the heat cycle resistance evaluation equipment or within less than 500 hours after the RF tag was placed into the constant temperature and constant humidity bath and an example in which an RF tag could not be produced (e.g., interlayer peeling was found during a production process or immediately after production), a rate of change of the value of inter-pattern resistance was evaluated as immeasurable.

A method for producing a polymeric material used in the examples will be described as a synthesis example.

### SYNTHESIS EXAMPLE 1, PRODUCTION OF GRAFT COPOLYMER

First, 8,500 g of pure water was added to a stainless steel autoclave with an internal volume of 20 L, and 750 g of a 1% by mass aqueous solution of polyvinyl alcohol was dissolved therein as a suspending agent. Then, 3,500 g of polypropylene to be described below was added thereto and was stirred and dispersed. Aside from this, 10.0 g of benzoyl peroxide as a radical polymerization initiator and 37.5 g of t-butyl peroxymethacryloyloxyethyl carbonate as a radical copolymerizable organic peroxide were dissolved in 1,080 g of styrene, which is a monofunctional aromatic vinyl monomer, and 300 g of divinylbenzene, which is a bifunctional aromatic vinyl monomer. This solution was charged into the autoclave and was stirred.

The temperature of the autoclave was raised to 85 to 95°C and was stirred for 2 hours to impregnate divinylbenzene and styrene containing benzoyl peroxide and t-butyl peroxymethacryloyloxyethyl carbonate into polypropylene. After that, the temperature was lowered to 75 to 85°C, and the autoclave was kept at the temperature for 5 hours to complete polymerization. The solution was filtered, washed with water, and dried to obtain a grafted precursor.

The grafted precursor was extruded at 210°C by a Labo Plastomill single screw extruder [manufactured by Toyo Seiki Seisaku-sho, Ltd.] and was subjected to a grafting reaction to obtain a graft resin. In addition, the graft resin was dry blended with 10 g of 1,3,5-trimethyl-2,4,6-tris(3,5-di-t-butyl-4-hydroxybenzyl)benzene and 10 g of neopentanetetraylbis(2,6-di-t-butyl-4-methylphenyl)phosphite as antioxidants. The mixture was then supplied to a coaxial twin screw extruder [TEX-30α, manufactured by The Japan Steel Works, Ltd.] with a screw diameter of 30 mm whose cylinder temperature was set to 210°C. The extruded article was pelletized to obtain a graft copolymer.
Polypropylene: [the product name "SunAllomer PM671A," manufactured by SunAllomer Ltd.]
Benzoyl peroxide: [the product name "NYPER BW," manufactured by NOF CORPORATION, a hydrous product with a purity of 75%]
t-butyl peroxymethacryloyloxyethyl carbonate: [manufactured by NOF CORPORATION, a 40% toluene solution]
1,3,5-trimethyl-2,4,6-tris(3,5-di-t-butyl-4-hydroxybenzyl)benzene: [the product name "Irganox 1330," manufactured by Ciba Specialty Chemicals Inc.]
Neopentanetetraylbis(2,6-di-t-butyl-4-methylphenyl)phosphite: [the product name "ADK STAB PEP-36," manufactured by ADEKA CORPORATION]

### SYNTHESIS EXAMPLES 2 TO 14, PRODUCTION OF GRAFT COPOLYMER

An aromatic vinyl monomer was graft-polymerized to various main chain structures by using the same method as that described in Synthesis Example 1 to obtain graft copolymers according to Synthesis Examples 2 to 14. The compositions of the graft copolymers are shown in Table 1.

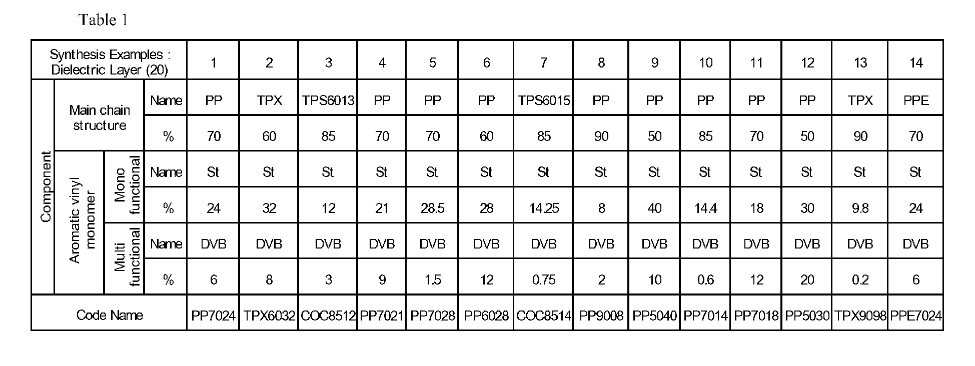

### Descriptions of abbreviations in Table 1 are as follows:

PP: polypropylene [the product name "SunAllomer PM671A," manufactured by SunAllomer Ltd., MFR: 7 g/(10 min)]
St: styrene
DVB: divinylbenzene
TPX: poly(4-methylpentene-1) [the product name "TPX RT18," manufactured by Mitsui Chemicals, Inc., MFR: 26 g/(10 min)]
TOPAS6013: an ethylene-norbornene copolymer [the product name "TOPAS 6013," manufactured by Polyplastics Co., Ltd., MFR: 14 g/(10 min)]
TOPAS6015: an ethylene-norbornene copolymer [the product name "TOPAS 6015," manufactured by Polyplastics Co., Ltd., MFR: 4 g/(10 min)]
PPE: polyphenylene ether [the product name "Iupiace," manufactured by MITSUBISHI GAS CHEMICAL COMPANY, INC.]

The compositions of prepregs (S1 to S6) used in the examples and the comparative examples are shown in Table 2.

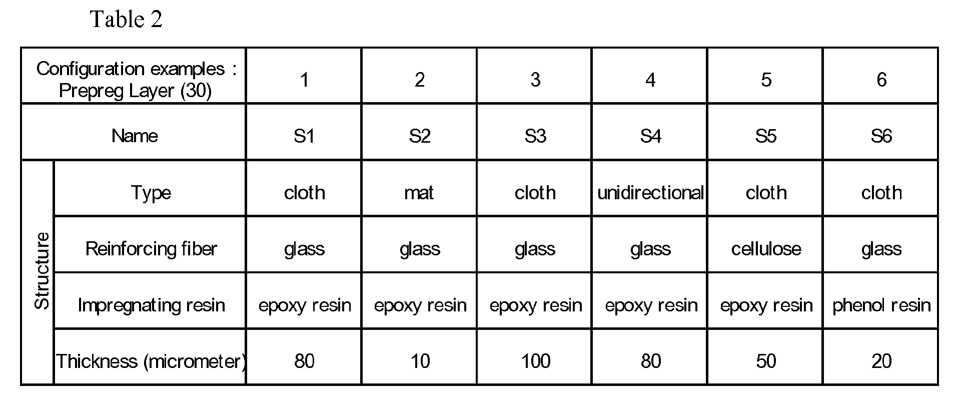

### EXAMPLE 1

The graft copolymer obtained in Synthesis Example 1 was formed into a plate by using an injection molding machine (manufactured by TABATA Industrial Machinery Co., Ltd.) to produce a dielectric layer (90 mm in length, 50 mm in width, and 4 mm in thickness).

A glass epoxy prepreg sheet (manufactured by Panasonic Electric Works Co., Ltd., R-1661, 90 mm in length, 50 mm in width, and 10 mm in thickness) for forming a prepreg layer was arranged on each surface of the dielectric layer. Thermal compression bonding was performed at 150°C by using a vacuum pressing machine (manufactured by KITAGAWA SEIKI CO., LTD.) to produce a prepreg plate.

An IC chip (storage medium) was mounted on rolled copper foil (manufactured by Fukuda Metal Foil & POWDER Co., LTD., 90 mm in length, 40 mm in width, and 18 µm in thickness) to produce an antenna circuit.

A recessed portion (with a diameter of 5 mm and a depth of 1 mm) was formed at one surface of the prepreg plate by using a drilling machine (manufactured by Hitachi Via Engineering, Ltd.) to prevent the IC chip mounted on the antenna circuit from projecting from the surface of an RF tag.

The recessed portion of the prepreg plate was filled with an IC chip sealing epoxy resin (manufactured by Sanyu REC Co., Ltd.) by using a screen printing machine (manufactured by Micro-tec Co., Ltd.).

The antenna circuit was arranged on the one surface of the prepreg plate such that the IC chip mounted on the antenna circuit was housed in the recessed portion of the prepreg plate whereas rolled copper foil (manufactured by Fukuda Metal Foil & POWDER Co., LTD., 90 mm in length, 50 mm in width, and 18 µm in thickness) for forming a metal foil layer was arranged on the other surface of the prepreg plate. In this state, thermal compression bonding was performed again at 150°C by using the vacuum pressing machine to obtain an RF tag.

### EXAMPLES 2 TO 9

The same method as that described in Example 1 was performed by using various ones of the dielectric layers shown in Table 1 and various ones of the prepreg layers shown in Table 2 to obtain RF tags according to Examples 2 to 9. The RF tags according to Examples 1 to 9 were each subjected to a heat cycle test and a high temperature and high humidity test. Results of the tests are shown in Table 3.

### EXAMPLE 10

An RF tag using the graft copolymer for forming a dielectric layer, the prepreg sheet for forming a prepreg layer, the antenna circuit, and the metal foil layer described in Example 1 was produced by using an injection molding machine (manufactured by TABATA Industrial Machinery Co., Ltd.) including an upper mold and a lower mold by the procedures below. The prepreg sheet was placed on the metal foil on a hole formed for evacuation of the lower mold, the melted graft copolymer was injected by using the injection molding machine, and a laminated body in which the metal foil layer, the prepreg layer, and the dielectric layer was stacked in this order was formed. After that, the antenna circuit was attached to the laminated body through the prepreg layer with an adhesive.

### EXAMPLE 11

A via (50) for electrical connection between the antenna circuit and the metal foil layer of the RF tag obtained in Example 1 was formed in the RF tag to produce an RF tag according to Example 11 (see Fig. 4(a)). A via hole (with a diameter of 1 mm) was made by using a drilling machine (manufactured by Hitachi Via Engineering, Ltd.) to extend through the antenna circuit and the metal foil layer, and a copper plated layer was formed on the inner surface of the via hole to form the via (50). A storage medium (11) and solder (13) are not shown in Figs. 4(a) to 4(e) for simplicity.

### EXAMPLE 12

The graft copolymer obtained in Synthesis Example 1 was formed into a film 90 mm in length, 50 mm in width, and 0.5 mm in thickness. The two surfaces of the graft copolymer film were subjected to surface modification by using UV-O₃ treatment equipment (manufactured by Senengineering Co., Ltd.). The graft copolymer film having undergone the surface modification and rolled copper foil (manufactured by Fukuda Metal Foil & POWDER Co., LTD.) with a thickness of 18 µm for forming a conductive layer were stacked in this order on one of surfaces of the antenna circuit of the RF tag obtained in Example 11 which is opposite to the prepreg layer. Thermal compression bonding was performed at 200°C by using a vacuum pressing machine (manufactured by KITAGAWA SEIKI CO., LTD.). After that, a via (50) was formed in the conductive layer and the antenna circuit in the same manner as in Example 11, and electrical continuity between the conductor layer and the antenna circuit was provided to obtain an RF tag (see Fig. 4(b)).

### EXAMPLE 13

Printing silver paste (manufactured by Fujikura Kasei Co., Ltd.) was screen printed to span the antenna circuit and the metal foil layer of the RF tag obtained in Example 1 by using a screen printing machine (manufactured by Micro-tec Co., Ltd.). After that, the printing silver paste was cured to form an end face electrode (60), and electrical continuity between the antenna circuit and the metal foil layer was provided. In this manner, an RF tag was obtained (see Fig. 4(c)).

### EXAMPLE 14

A square bracket-shaped "]" metal fastener was fit on the RF tag obtained in Example 1 to span the antenna circuit and the metal foil layer of the RF tag. An end face electrode (60) was formed to provide electrical continuity between the antenna circuit and the metal foil layer. In this manner, an RF tag was obtained (see Fig. 4(d)).

### EXAMPLE 15

Conductive aluminum adhesive tape (manufactured by TERAOKA SEISAKUSHO CO., LTD.) was affixed to span the antenna circuit and the metal foil layer of the RF tag obtained in Example 1. An end face electrode (60) was formed to provide electrical continuity between the antenna circuit and the metal foil layer. In this manner, an RF tag was obtained (see Fig. 4(e)).

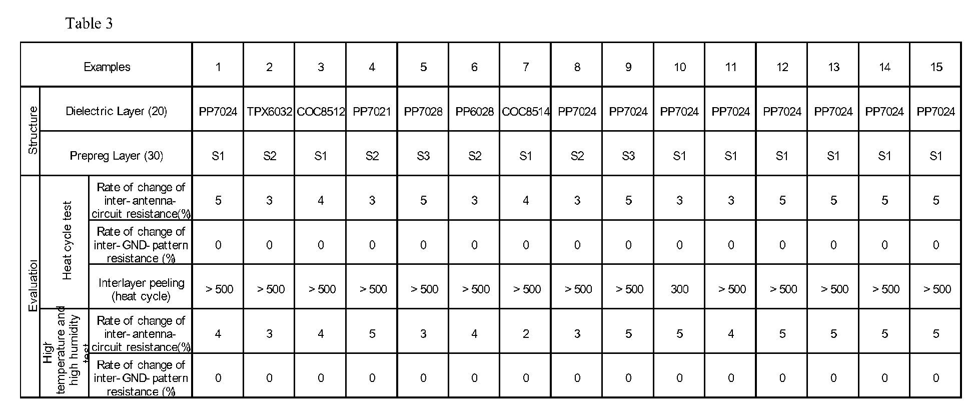

As can be seen from the results shown in Table 3, the RF tags according to Examples 1 to 9 and 11 to 15 each exhibited good heat cycle resistance, i.e., did not suffer from interlayer peeling for not less than 500 cycles. Also, a rate of change of the value of inter-antenna-circuit resistance and a rate of change of the value of inter-GND-pattern resistance in a heat cycle test and those in a constant temperature and constant humidity test of each RF tag were all as low as not more than 5%, and the obtained RF tags achieved high reliability. In Example 10, the laminated body was formed by injection molding, and the antenna circuit was bonded to the laminated body through the prepreg sheet with the adhesive. With this configuration, Example 10 exhibited slightly lower heat cycle resistance (300 cycles) than Examples 1 to 9 and 11 to 15 but was otherwise equivalent to Examples 1 to 9.

### COMPARATIVE EXAMPLES 1 TO 9

The same method as that described in Example 1 was performed by using various ones of the dielectric layers shown in Table 1 and various ones of the prepreg layers shown in Table 2 to obtain various RF tags. The obtained RF tags according to Comparative Examples 1 to 9 were each subjected to a heat cycle test and a constant temperature and constant humidity test. Results of the tests are shown in Table 4.

### COMPARATIVE EXAMPLE 10

The same method as that described in Example 11 was performed by using various ones of the dielectric layers shown in Table 1 and various ones of the prepreg layers shown in Table 2 to obtain an RF tag. The obtained RF tag according to Comparative Example 10 was subjected to a heat cycle test and a constant temperature and constant humidity test. Results of the tests are shown in Table 4.

### COMPARATIVE EXAMPLE 11

The same method as that described in Example 11 was performed by using various ones of the dielectric layers shown in Table 1 and various ones of the prepreg layers shown in Table 2 to obtain various RF tags. The obtained RF tags according to Comparative Example 11 were subjected to a heat cycle test and a constant temperature and constant humidity test. Results of the tests are shown in Table 4.

### COMPARATIVE EXAMPLE 12

The same method as that described in Example 12 was performed by using various ones of the dielectric layers shown in Table 1 and various ones of the prepreg layers shown in Table 2 to obtain various RF tags. The obtained RF tags according to Comparative Example 12 were subjected to a heat cycle test and a constant temperature and constant humidity test. Results of the tests are shown in Table 4.

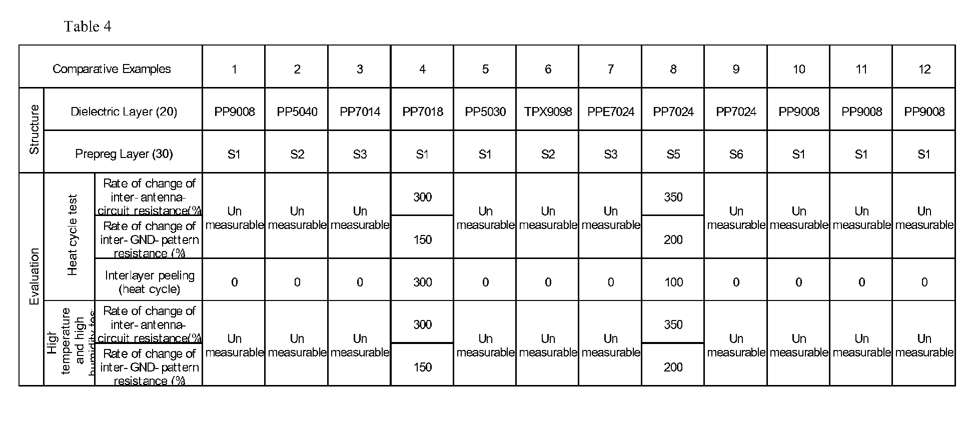

In each of Comparative Examples 1, 11, and 12, the proportion of an aromatic vinyl monomer for forming a graft copolymer was low, resulting in high flowability of the graft copolymer. The graft copolymer flowed at the time of thermal compression bonding, and a dielectric layer (P) could not be formed. In contrast, in Comparative Example 2, the proportion of an aromatic vinyl monomer (b) for forming a graft copolymer was high, resulting in high brittleness of the graft copolymer. A first dielectric layer (20a) and a second dielectric layer (20b) could not be formed.

In Comparative Example 3, the proportion of a bifunctional aromatic vinyl monomer (b2) forming a domain of a graft copolymer was low, resulting in high flowability of the graft copolymer. Control of the thickness of the graft copolymer was hard, which led to the difficulty of forming a first dielectric layer (20a). In contrast, in Comparative Example 4, the proportion of a bifunctional aromatic vinyl monomer (b2) forming a domain of a graft copolymer was high. The results showed rates of change of inter-antenna-circuit resistance and rates of change of inter-GND-pattern resistance in the heat cycle test and the constant temperature and constant humidity test were extremely high.

In Comparative Example 5, the proportion of an aromatic vinyl monomer (b) forming a graft copolymer was high, and the proportion of a bifunctional aromatic vinyl monomer (b2) forming a domain of the graft copolymer was high. The graft copolymer was brittle and could not be formed into a plate. In contrast, in Comparative Example 6, the proportion of an aromatic vinyl monomer (b) forming a graft copolymer was low, and the proportion of a bifunctional aromatic vinyl monomer (b2) forming a domain of the graft copolymer was low. The graft copolymer thus exhibited very high flowability, and a first dielectric layer (20a) with a uniform thickness could not be obtained.

In Comparative Example 7, polyphenylene ether was used as a matrix resin for forming a graft copolymer, resulting in a failure to synthesize the graft copolymer.

In Comparative Example 8, a cellulose fiber was used as a reinforcing fiber for prepreg layers (30a, 30b), resulting in susceptibility to a temperature change and humidity in the heat cycle test and the constant temperature and constant humidity test. Satisfactory heat cycle resistance could not be achieved. In Comparative Example 9, a phenol resin was used as a resin for forming prepregs (30a, 30b), resulting in a failure to achieve sufficient adhesion to a first dielectric layer (20a). Interlayer peeling occurred immediately after thermal compression bonding, and an RF tag could not be formed.

### DESCRIPTION OF THE REFERENCE NUMERALS

- 20a, 20b: dielectric layer
- 30a, 30b: prepreg layer
- 10: antenna circuit
- 11: storage medium
- 12a, 12b: conductive layer
- 40: metal foil layer

## Claims

1. An RF tag comprising:
a prepreg plate which is composed of a first dielectric layer (20a) and two prepreg layers (30a, 30b) which are arranged on two major surfaces, respectively, of the first dielectric layer (20a); and
an antenna circuit (10) and a metal foil layer (40) which are stacked on the two prepreg layers (30a, 30b), respectively, of the prepreg plate, wherein:
the first dielectric layer (20a) is made of a graft copolymer which is obtained by graft-polymerizing 15 to 40 parts by mass of an aromatic vinyl monomer (b), which contains 70 to 95% by mass of a monofunctional aromatic vinyl monomer (b1) and 5 to 30% by mass of a bifunctional aromatic vinyl monomer (b2), onto 60 to 85 parts by mass of a polymer (a), which is composed of a monomer unit derived from an α-olefin monomer or a chain conjugated diene monomer,
each of the two prepreg layers (30a, 30b) is an epoxy resin-impregnated glass fiber base material which is obtained by impregnating a glass fiber base material with an epoxy resin,
the antenna circuit (10) includes a first conductive layer (12a) and an information readable-writable storage medium (11) mounted on the first conductive layer (12a),
the two prepreg layers (30a, 30b) are bonded to the two major surfaces, respectively, of the first dielectric layer (20a) by thermal compression bonding, and
the antenna circuit (10) and the metal foil layer (40) are bonded to the two prepreg layers (30a, 30b), respectively, of the prepreg plate by thermal compression bonding.

2. The RF tag according to claim 1, wherein the first conductive layer (12a) and the metal foil layer (40) are electrically continuous.

3. The RF tag according to claim 1 or 2, wherein:
the RF tag comprises a second dielectric layer (20b) and a second conductive layer (12b) which are stacked in this order on one opposite to the prepreg layer (30b) of surfaces of the first conductive layer (12a), and the first conductive layer (12a) and the second conductive layer (12b) are electrically continuous, and
the second dielectric layer (20b) is made of a graft copolymer which is obtained by graft-polymerizing 15 to 40 parts by mass of the aromatic vinyl monomer (b), which contains 70 to 95% by mass of the monofunctional aromatic vinyl monomer (b1) and 5 to 30% by mass of the bifunctional aromatic vinyl monomer (b2), onto 60 to 85 parts by mass of the polymer (a), which is composed of the monomer unit derived from the α-olefin monomer or the chain conjugated diene monomer, and
the first conductive layer (12a), the second dielectric layer (20b), and the second conductive layer (12b) are bonded in this order by thermal compression bonding.

4. The RF tag according to claim 2 or 3, further comprising a via (50) for the electrical continuity.

5. The RF tag according to claim 2 or 3, further comprising an end face electrode (60) for the electrical continuity.

6. A method for producing an RF tag according to claim 1, the method comprising steps (A) and (B),
wherein the step (A) is a step of bonding the two prepreg layers (30a, 30b) to the two major surfaces, respectively, of the first dielectric layer (20a) by thermal compression bonding to produce the prepreg plate, and
the step (B) is a step of bonding the antenna circuit (10) and the metal foil layer (40) to the two prepreg layers (30a, 30b), respectively, of the prepreg plate by thermal compression bonding.
